# FASCICULE DE BREVET EUROPEEN

(11) **EP 1 312 161 B1**
(45) Date de publication et mention de la délivrance du brevet: **07.10.2009**
(21) Numéro de dépôt: 01984373.9
(22) Date de dépôt: 09.07.2001
(51) Int. Cl.: H03F 3/72

(54) **BLOC D'AMPLIFICATION DE SIGNAUX RF, DISPOSITIF D'EMISSION DE SIGNAUX RF ET TERMINAL-ANTENNE D'EMISSION DE SIGNAUX RF**
HOCHFREQUENZSIGNALVERSTÄRKEREINHEIT, HOCHFREQUENZSIGNALSENDEGERÄT, HOCHFREQUENZSIGNALENDGERÄT UND HOCHFREQUENZSIGNALANTENNE
RF SIGNAL AMPLIFIER UNIT, RF SIGNAL TRANSMISSION DEVICE AND RF SIGNAL TRANSMITTING TERMINAL-ANTENNA

(30) Priorité: 21.07.2000 FR 0009571
(43) Date de publication de la demande: 21.05.2003
(73) Titulaire: Thomson Licensing, 92100 Boulogne-Billancourt (FR)
(72) Inventeur: HIRTZLIN, Patrice, F-35830 Betton (FR); LE NAOUR, Jean-Yves, F-35740 Pace (FR); WURM, Patrick, Cambridge, Cambridgeshire CB37DL (GB)
(74) Mandataire: Ruellan-Lemonnier, Brigitte
(86) Numéro de dépôt international: PCT/FR2001/002197
(87) Numéro de publication internationale: WO 2002/009276

(56) Documents cités:
- EP-A- 0 982 854
- US-A- 5 256 987
- US-A- 5 831 479

## Description

La présente invention se rapporte au domaine des télécommunications et concerne plus particulièrement un bloc d'amplification de signaux radiofréquence ou RF.

L'invention concerne également un dispositif d'émission de signaux RF destiné à être agencé au foyer de moyens de focalisation de signaux RF, notamment mais non exclusivement du type d'une parabole ou d'une lentille de type Luneberg.

L'invention concerne également un terminal-antenne comprenant des moyens de focalisation de signaux RF au foyer desquels est agencé au moins un dispositif tel que cité ci-dessus. Elle concerne plus particulièrement mais non exclusivement un tel terminal comprenant deux dispositifs tels que cités ci-dessus pour la poursuite de cibles, du type de satellites notamment à défilement, un seul de ces deux dispositifs étant destiné à être actif à un instant donné.

Jusqu'à présent, les télécommunications commerciales par satellite ont été réalisées en quasi-totalité par les satellites géostationnaires, particulièrement intéressants en raison de leurs positions relatives immuables dans le ciel. Or, le satellite géostationnaire présente des inconvénients majeurs tel que des atténuations importantes des signaux transmis liées à la distance séparant les antennes usagers du satellite géostationnaire (de l'ordre de 36000 kilomètres, les pertes correspondantes s'élevant alors à environ 205 dB dans la bande Ku) et des délais de transmission (typiquement de l'ordre de 250 ms à 280 ms) devenant ainsi nettement perceptibles et gênants notamment pour des applications en temps réel telles que la téléphonie, la vidéoconférence, etc... Par ailleurs, l'orbite géostationnaire, située dans le plan équatorial, pose un problème de visibilité pour les régions à latitudes élevées, les angles d'élévation devenant très faibles pour les régions proches des pôles.

Les alternatives à l'emploi du satellite géostationnaire sont :
- l'utilisation de satellites sur des orbites elliptiques inclinées, le satellite étant alors quasi-stationnaire au-dessus de la région située à la latitude de son apogée pendant une durée pouvant atteindre plusieurs heures,
- la mise en oeuvre de constellations de satellites en orbites circulaires, notamment en orbite basse («Low Earth Orbit » ou LEO en langue anglaise) ou en orbite moyenne (« Mid Earth Orbit » ou MEO en langue anglaise), les satellites de la constellation défilant à tour de rôle en visibilité du terminal usager pendant une durée allant d'une dizaine de minutes à environ une heure.

Dans les deux cas, le service ne peut être assuré en permanence par un seul satellite, la continuité du service imposant le défilement au-dessus de la zone de service de plusieurs satellites se succédant les uns aux autres.

Un terminal-antenne tel que défini dans le préambule permet de s'assurer de la communication constante du terminal en émission avec la constellation de satellites à défilement.

Un tel terminal comprend couramment une parabole ou une lentille de type de Luneberg au foyer de laquelle se trouvent agencés deux sources comprenant couramment des éléments rayonnants, du type de réseaux de "patchs", cornets ou autres éléments rayonnants pour l'émission de signaux RF. Ces éléments sont alimentés par un bloc amplificateur permettant de fournir à la source un signal amplifié. En amont de ce bloc amplificateur se trouve une unité centrale permettant de gérer les passages de relais ("Hand Over" en langue anglaise) entre deux satellites successifs à orbite basse dans l'espace de rayonnement. Il est certain qu'une seule source doit être active à un instant donné, sauf pendant les passages de relais où se pose le problème de l'activation de la source jusqu'alors inactive.

Le bloc amplificateur a pour rôle d'amplifier suffisamment le signal pour pouvoir être perceptible du satellite. Il doit émettre à une puissance nominale prédéterminée par le calcul du bilan de liaison terminal-satellite. En effet, si l'émission est réalisée en deçà de la puissance nominale, le satellite récupère un signal de faible niveau alors que si l'émission est effectuée au-delà de la valeur de la puissance nominale, le signal véhicule des distorsions susceptibles de brouiller, au niveau du satellite, la réception des informations contenues dans le signal (notamment si la modulation du signal effectuée est du type CDMA).

Le document US 5 256 987 décrit un amplificateur dont le gain est commandé par un signal ATT-CONTk afin que le gain devienne égal à un niveau prédéterminé. La puissance de sortie mesurée permet de connecter graduellement divers unité d'amplification par la commande de divers commutateurs.

L'initialisation du bloc amplificateur inactif passant de l'état inactif à l'état actif est réalisé lors du passage de relais.Au cours du passage de relais, le bloc amplificateur doit amplifier à puissance nominale et ce, dès les premières millisecondes, au risque de perdre les premières données utiles envoyées vers le satellite suivant. Or, l'émission immédiate ou quasi-immédiate à la puissance nominale lors du passage de relais est difficile à maîtriser, dû à des facteurs susceptibles de faire varier le gain du bloc tels que la dispersion des composants, les variations d'alimentation, des fréquences d'émission, de température, de la résistance thermique entre la jonction d'un transistor de puissance et le boîtier contenant l'amplificateur, etc. Si l'effet dispersif de certains paramètres peut être réduit par calibrage en usine, il en existe d'autres qui sont plus difficiles à contrôler tels que la température de jonction, rendant quasi-impossible la maîtrise instantanée de la puissance d'émission avec la précision requise par les spécifications du système satellitaire. De ce fait, le bloc amplificateur met un certain temps avant d'amplifier à la puissance nominale prédéterminée.

L'invention vise à remédier aux problèmes cités ci-dessus.

A cet effet, l'invention a pour objet un bloc d'amplification de signaux RF pour coopérer avec une unité centrale (8), comprenant une première entrée (E1) pour recevoir un premier signal RF (RFin), des moyens d'amplification (3, 4, 12, 15) de ce premier signal RF pour délivrer un second signal RF (RF1) amplifié, des moyens de mesure (7) de la puissance du second signal RF (RF1) amplifié, caractérisé en ce que ledit bloc comprend :
- des moyens de couplage (5, 16) du signal RF amplifié vers une première sortie (S1) du bloc à réception d'un signal de commande de connexion,
- une seconde entrée pour recevoir le signal de commande (Sc) de connexion généré par l'unité centrale pour commander les moyens de couplage lorsque la puissance du signal RF amplifié est égale à une valeur de puissance nominale (Pout).

Ainsi, le bloc selon l'invention assure de délivrer en sortie, lors du passage de relais, un signal de puissance passant d'une puissance nulle à la puissance nominale prédéterminée.

Pour qu'un bloc puisse être produit selon une production de masse caractérisé par une exigence de coût peu élevé, celui-ci comporte deux voies de traitement du premier signal RF, les moyens d'amplification comportant des premiers et des seconds moyens d'amplification agencés respectivement sur la première et la seconde voie de traitement pour délivrer chacun un troisième signal RF amplifié de même puissance, lesdits moyens de couplage étant aptes à recevoir en entrée lesdits troisièmes signaux RF et à délivrer sur une seconde sortie de la première voie reliée à la première sortie un signal différence correspondant à la différence desdits troisièmes signaux et sur une troisième sortie de la seconde voie un signal somme correspondant à la somme des troisièmes signaux equivalent audit second signal pour être mesuré par lesdits moyens de mesure, les moyens de couplage étant aptes à permuter les seconde et troisième sorties.

De cette sorte, l'invention permet d'une part d'éviter l'utilisation d'un commutateur hyperfréquence coûteux en soi, d'autre part d'utiliser des premiers et seconds moyens d'amplification partageant de façon égale la fonction d'amplification en opérant de façon parallèle. Ces derniers devant amplifier à une puissance moitié moindre présentent les avantages d'être moins coûteux et de fabrication plus aisée.

Pour que les deux moyens d'amplification délivrent des signaux de gains et de phases identiques de manière à ce que la combinaison additive ou différentielle de ces derniers soient respectivement constructive ou destructive, lesdites voies de traitement comportent des moyens d'atténuation de gain et des premiers moyens de déphasage de signaux. De cette sorte, la phase du signal véhiculé sur la seconde voie est suffisamment ajustée pour maximiser la puissance produite.

Selon un mode de réalisation, ledit bloc devant amplifier à gain élevé et à un fort niveau de puissance, l'un au moins desdits premiers et seconds moyens d'amplification est précédé d'un préamplificateur couramment appelé "Driver" en langue anglaise, et additionnellement, l'un au moins de ces premiers et seconds moyens d'amplification comporte un amplificateur de puissance à état solide ("Solid State Power Amplifier" ou "SSPA" en langue anglaise).

Selon un mode de réalisation, lesdits moyens de couplage comprennent un coupleur hybride. Ainsi, la perte très modérée du coupleur hybride n'oblige pas à surdimensionner le point de compression du SSPA.

Selon un mode de réalisation, l'une desdites voies comporte des seconds moyens de déphasage à 180° destinés à être commandés par lesdits moyens de commande pour réaliser ladite permutation de la délivrance desdits signaux. Lesdits moyens de déphasage à 180° sont par exemple un déphaseur à faible niveau de puissance.

Selon une variante, lesdits moyens de couplage comprennent un commutateur hyperfréquence.

L'invention concerne également un dispositif d'émission de signaux RF destiné à être agencé au foyer de moyens de focalisation de signaux RF, du type d'une parabole ou d'une lentille de type de Luneberg, caractérisé en ce qu'il comporte un bloc d'amplification selon l'invention.

L'invention concerne également un terminal-antenne d'émission de signaux RF comprenant des moyens de focalisation de signaux RF au foyer desquels est agencé au moins un dispositif d'émission de signaux RF, caractérisé en ce que ledit dispositif comprend un dispositif selon l'invention.

D'autres caractéristiques et avantages de la présente invention ressortiront de la description des exemples de réalisation qui vont suivre, pris à titre d'exemples non limitatifs, en référence aux figures annexées dans lesquelles :
- la figure 1 illustre un premier mode de réalisation d'un bloc d'amplification selon l'invention,
- la figure 2 illustre un second mode de réalisation d'un bloc d'amplification selon l'invention.

Pour simplifier la description, les mêmes références seront utilisées dans ces dernières figures pour désigner les éléments remplissant des fonctions identiques.

Les demandes de brevets n° 9805111 ET 9805112 déposées le 23 avril 1998 au nom de la Demanderesse décrivent des terminaux-antennes pour la poursuite de satellites à défilement selon des trajectoires prédéfinies. Par exemple, dans la demande n° 9805111, le terminal-antenne comporte au moins des premières et seconde sources réceptrices / émettrices pouvant se déplacer le long de la surface de focalisation de la lentille de Luneberg selon une ligne de points focaux, la première source poursuivant activement un premier satellite et la deuxième source demeurant en attente de poursuite active d'un deuxième satellite. La chaîne d'émission du signal fait intervenir depuis l'unité intérieure jusqu'à l'unité extérieure représentée par le terminal-antenne une modulation réalisée au niveau d'un modem, au moins une transposition permettant de transposer le signal en hautes fréquences (en bandes Ku par exemple pour un système de constellation de satellite à orbite basse), puis une amplification avec un gain élevé à un fort niveau de puissance.

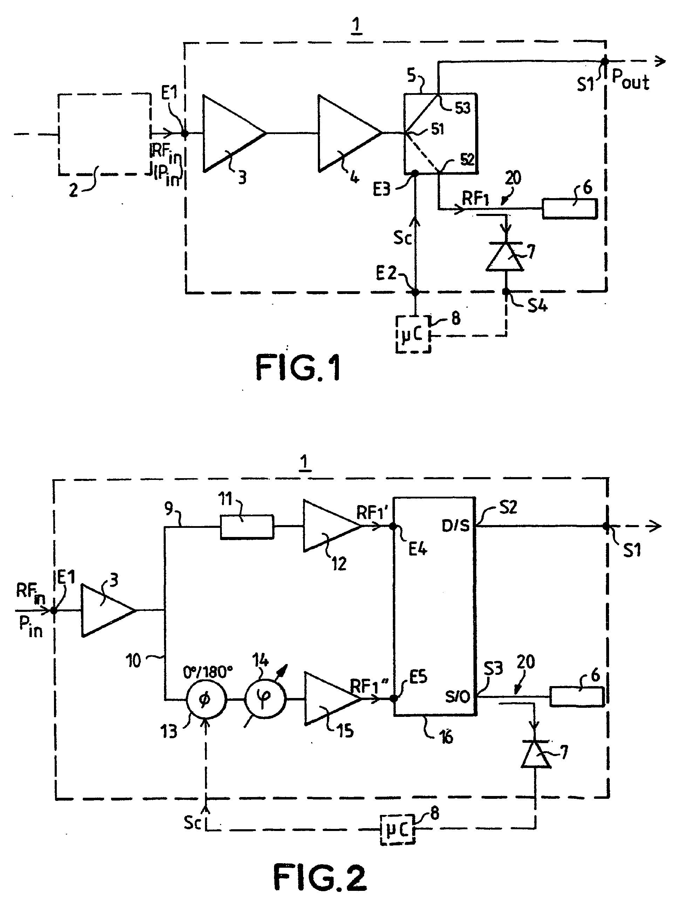

Dans la figure 1, le bloc d'amplification 1 comprend une première entrée E1 recevant un signal RFin provenant d'un bloc de transposition 2 ayant transposé le signal d'entrée en bande Ku par exemple. L'entrée E1 est reliée à un préamplificateur 3 dont le signal de sortie est lui-même amplifié par un amplificateur de puissance 4 SSPA. Ces deux amplificateurs sont réalisés en technologie MMIC (« Microwave Monolitic Integrated Circuit » en langue anglaise). La sortie du deuxième amplificateur 4 est reliée à une première borne 51 de connexion d'un interrupteur 5 hyperfréquence. Une deuxième borne 52 de connexion relie, au moyen d'un coupleur 20 le commutateur à une diode 7 de détection et de mesure (connue en soi) de la puissance du signal de sortie de l'amplificateur 4, la diode étant reliée à une sortie S4 du bloc. La ligne reliant la borne 52 à la diode 7 est adaptée par une impédance de charge 6 de 50 Ω. Une troisième borne 53 de connexion relie le commutateur à une sortie S1 du bloc 1. Cette sortie est reliée à une source placée sensiblement au foyer du terminal-antenne non représenté.

Les instants de transfert de relais sont connus d'une unité centrale 8, par exemple un microcontrôleur 8 (disposé dans l'unité intérieure ou dans le terminal-antenne) grâce à une éphéméride comportant les caractéristiques nécessaires à la maîtrise des trajectoires des satellites de la constellation. Ainsi, en mode de fonctionnement, pour un transfert de relais à T0, le microcontrôleur estime la nouvelle puissance Pout à employer pour l'émission du signal vers le satellite (en fonction du nouveau bilan de liaison qui peut être modifié par l'utilisation d'une nouvelle fréquence d'émission, par exemple. Cette information est émise dans le signal émis par le satellite). A partir d'un certain temps t1 antérieur à l'instant de transfert T0, l'unité centrale fait émettre un signal de puissance Pin à l'entrée E1 et transmet sur une entrée E2 du bloc reliée à une entrée E3 du commutateur un signal de commande Sc pour commander la connexion de la borne 51 à la borne 52. La puissance en sortie de l'amplificateur 4 est alors mesurée par la diode 7. Cette mesure est transmise au microcontrôleur qui commande l'incrémentation du signal de puissance Pin lors de la montée en régime de cette puissance. Cette phase de mesure et d'incrémentation de la puissance définit le bloc comme étant dans un état inactif pendant lequel il ne peut pas délivrer de signal sur sa sortie S1.

Lorsque la puissance mesurée à la sortie de l'amplificateur 4 est alors égale à la puissance Pout et le moment T0 est atteint, le microcontrôleur 8 commande via le signal Sc la connexion de la borne 51 sur la borne 53, reliant ainsi la sortie de l'amplificateur 4 à la sortie S1.

La puissance en sortie du dispositif 1 est alors égale à la valeur nominale appliquée pour que l'antenne puisse émettre de façon optimale. Dans cette configuration, le bloc délivrant un signal de puissance optimale Pout à sa sortie S1 est dans un état dit actif.

La figure 2 représente un autre mode de réalisation du bloc 1 selon l'invention. Une première entrée E1 de celui-ci est reliée à un préamplificateur 3 dont une sortie est reliée à deux voies 9 et 10 parallèles. Par la voie 2, la sortie de l'amplificateur 3 est reliée à une entrée d'un atténuateur de gain 11 dont une sortie attaque une entrée d'un amplificateur de puissance 12. Par la voie 10, la sortie de l'amplificateur 3 est reliée à l'entrée d'un déphaseur 13 apte à déphaser le signal à son entrée de 0° ou 180°. Le signal ainsi déphasé est alors délivré à un déphaseur 14 qui a pour fonction d'ajuster la phase du signal véhiculé sur cette voie avec celui de la deuxième voie. Une sortie de ce déphaseur est reliée à une entrée d'un amplificateur 15. Une sortie de chacun des deux amplificateurs 12 et 15 délivre respectivement un signal amplifié RF1', RF1" à une entrée respective E4, E5 d'un coupleur hybride 16 qui délivre sur une première S2 de ses sorties la différence des signaux RF1' et RF1" délivrés par les deux amplificateurs et sur une seconde S3 des sorties du coupleur 16 la somme de ces signaux RF1' et RF1". Cette dernière sortie S3, adaptée en bout par une impédance de charge 6 de 50 Ω, est également reliée à une diode 7 de mesure de la puissance du signal somme sortant de S3. Cette diode 7 délivre un signal de mesure à la sortie S4 reliée à un microcontrôleur 8.

Pour que le bloc opère de façon satisfaisante, il faut que les deux amplificateurs présentent un gain et une phase identiques afin que leurs signaux respectifs de sortie soient constructifs. Ceci est réalisé grâce à l'atténuateur 11 et au déphaseur 14 qui sont réglés en usine.

La phase d'initialisation de la procédure d'asservissement de la puissance d'émission est déclenchée dès que le microprocesseur reçoit l'ordre de se préparer à gérer un transfert de relais (par exemple par un mot indicatif dans le signal reçu du satellite et/ou grâce à l'éphéméride).

Tant que le signal en sortie S3 n'émet pas une puissance nominale prédéterminée, le microcontrôleur incrémente la puissance d'entrée Pin selon des moyens connus en soi. Une fois qu'une valeur seuil de mesure de la puissance du signal somme est atteinte, par exemple : "Pout moins 20 dB", le microcontrôleur détermine la puissance d'entrée Pin correspondante, et, le gain de la chaîne étant sensiblement constant, il détermine alors la nouvelle puissance d'entrée Pin à émettre à l'entrée E1 du bloc pour que la chaîne d'amplification émette en sortie de l'amplificateur 15 une puissance Pout égale à la puissance nominale requise (la relation entre la puissance d'entrée et la puissance de sortie de la chaîne étant linéaire).

Une fois que la puissance Pout est atteinte en sortie S3, le microcontrôleur attend le signal d'ordre à l'instant T0 de transfert effectif de relais pour envoyer la commande au déphaseur 13 d'inverser la phase du signal transitant dans la seconde voie de façon à inverser les sorties du coupleur hybride. De cette sorte, toute la puissance est alors dirigée vers la sortie S1 destinée à la source.

Le bloc selon l'invention permet ainsi de calibrer la puissance fournie à la source sans risque de perte de données utiles lors du transfert de relais, garantissant que les premières données utiles émises le seront à la puissance nominale requise.

L'utilisation de deux amplificateurs SSPA au lieu d'un seul permet de diminuer la puissance de sortie de chacun d'eux de trois décibels et d'autant leur point de compression. Le coût de la chaîne d'amplification du terminal en est réduit et sa faisabilité augmentée. De plus, le déphaseur de commutation à 180° est un élément opérant à faible niveau de puissance dont le niveau n'influe guère sur la chaîne d'amplification car les amplificateurs SSPA, souvent de technologie MMIC et à plusieurs étages, fournissent un gain élevé prédominant sur le niveau du déphaseur.

Bien entendu, l'invention n'est pas limitée aux modes de réalisation décrits ci-dessus. Ainsi, le bloc selon l'invention peut avoir le rôle d'amplification pour tout type de terminal devant générer une puissance nominale à un instant donné. De même, le terminal n'est pas limité à la poursuite de cibles mouvantes telles que présentées dans l'introduction de la présente demande. Le bloc peut par exemple être disposé dans un terminal-antenne pour la communication avec un satellite géostationnaire, son rôle étant ici encore d'amplifier à un instant donné un signal non amplifié à la puissance nominale requise, permettant l'émission d'un signal sans perte de données utiles.

## Revendications

1. Bloc d'amplification de signaux RF pour coopérer avec une unité centrale (8), comprenant une première entrée (E1) pour recevoir un premier signal RF (RFin), des moyens d'amplification (3, 4, 12, 15) de ce premier signal RF pour délivrer un second signal RF (RF1) amplifié, - des moyens de mesure (7) de la puissance du second signal RF (RF1) amplifié, **caractérisé en ce que** ledit bloc comprend :
- des moyens de couplage (5, 16) du signal RF amplifié vers une première sortie (S1) du bloc à réception d'un signal de commande de connexion,
- une seconde entrée pour recevoir le signal de commande (Sc) de connexion généré par l'unité centrale pour commander les moyens de couplage lorsque la puissance du signal RF amplifié est égale à une valeur de puissance nominale (Pout).

2. Bloc selon la revendication 1, **caractérisé en ce que** lesdits moyens de couplage comprennent un commutateur hyperfréquence (5).

3. Bloc selon la revendication 1, **caractérisé en ce que** ledit bloc comporte deux voies (9, 10) de traitement du premier signal RF (RF1), les moyens d'amplification comportant des premiers (12) et des seconds (15) moyens d'amplification agencés respectivement sur la première (9) et la seconde (10) voie de traitement pour délivrer chacun un troisième signal RF (RF1', RF1") amplifié de même puissance, lesdits moyens de couplage (16) étant aptes à recevoir en entrée lesdits troisièmes signaux RF et à délivrer sur une seconde sortie (S2) de la première voie reliée à la première sortie (S1) un signal différence correspondant à la différence desdits troisièmes signaux et sur une troisième sortie (S3) de la seconde voie un signal somme correspondant à la somme des troisièmes signaux équivalent audit second signal pour être mesuré par lesdits moyens de mesure, les moyens de couplage étant aptes à permuter les seconde et troisième sorties (S2, S3).

4. Bloc selon la revendication 3, **caractérisé en ce que** lesdites voies de traitement comportent des moyens d'atténuation (11) de gain et des premiers moyens de déphasage (14) de signaux.

5. Bloc selon l'une des revendications 3 à 4, **caractérisé en ce que** l'un au moins desdits premiers et seconds moyens d'amplification est précédé d'un préamplificateur (3).

6. Bloc selon l'une des revendications 3 à 5, **caractérisé en ce que** l'un au moins des premiers et seconds moyens d'amplification comprend un amplificateur de puissance à état solide SSPA.

7. Bloc selon l'une des revendications 3 à 6, **caractérisé en ce que** lesdits moyens de couplage comprennent un coupleur hybride.

8. Bloc selon l'une des revendications 3 à 7, **caractérisé en ce que** l'une desdites voies comporte des seconds moyens de déphasage (13) à 180° destinés à être commandés par lesdits moyens de commande pour réaliser ladite permutation de la délivrance desdits signaux.

9. Dispositif d'émission de signaux RF destiné à être agencé au foyer de moyens de focalisation de signaux RF, du type d'une parabole ou d'une lentille de type de Luneberg, **caractérisé en ce qu'**il comporte un bloc d'amplification selon l'une des revendications 1 à 8.

10. Terminal-antenne d'émission de signaux RF comprenant des moyens de focalisation de signaux RF au foyer desquels est agencé au moins un dispositif d'émission de signaux RF, **caractérisé en ce que** ledit dispositif comprend un dispositif selon la revendication 9.

## Claims

1. RF signals amplification block for cooperating with a central processing unit (8), comprising a first input (E1) for receiving a first RF signal (RFin), means of amplification (3, 4, 12, 15) of this first RF signal so as to deliver a second, amplified, RF signal (RF1),:
- means of measurement (7) of the power of the second, amplified, RF signal (RF1), **characterized in that** the said block comprises:
- means of coupling (5, 16) the amplified RF signal to a first output (S1) of the block, at the receipt of the connection control signal,
- a second input for receiving the control signal (Sc) generated by the central processing unit so as to control the means of coupling as a function of the comparison between the power of the amplified RF signal and a nominal power value (Pout).

2. Block according to claim 1, **characterized in that** the said coupling means comprise a microwave frequency switch (5).

3. Block according to claim 1, **characterized in that** the said block comprises two channels (9, 10) for processing the first RF signal (RF1), the amplification means comprising first (12) and second (15) amplification means arranged respectively on the first (9) and the second (10) processing channel so as each to deliver a third, amplified, RF signal (RF1', RF1") of the same power, the said coupling means (16) being able to receive at input the said third RF signals and to deliver on a second output (S2) of the first channel linked to the first output (S1) a difference signal corresponding to the difference of the said third signals and on a third output (S3) of the second channel a sum signal which corresponds to the sum of the third signals and is equivalent to the said second signal so as to be measured by the said means of measurement, the coupling means being able to permute the second and third outputs (S2, S3).

4. Block according to claim 3, **characterized in that** the said processing channels comprise gain attenuation means (11) and first means (14) of phase-shifting of signals.

5. Block according to one of claims 3 to 4, **characterized in that** at least one of the said first and second amplification means is preceded by a preamplifier (3).

6. Block according to one of claims 3 to 5, **characterized in that** at least one of the first and second amplification means comprises a solid state power amplifier SSPA.

7. Block according to one of claims 3 to 6, **characterized in that** the said coupling means comprise a hybrid coupler.

8. Block according to one of claims 3 to 7, **characterized in that** one of the said channels comprises second means of 180° phase-shifting (13) intended to be controlled by the said control means so as to carry out the said permutation of the delivery of the said signals.

9. RF signals transmission device intended to be arranged at the focus of RF signals focusing means, of the type of a parabola or of a lens of Luneberg type, **characterized in that** it comprises an amplification block according to one of claims 1 to 8.

10. RF signals transmission antenna/terminal comprising RF signals focusing means at the focus of which is arranged at least one RF signals transmission device, **characterized in that** the said device comprises a device according to claim 9.

## Patentansprüche

1. Baugruppe zur Verstärkung von Hochfrequenzsignalen, die dazu bestimmt ist, mit einer Zentraleinheit (8) zusammenzuwirken, mit einem ersten Eingang (E1) zum Empfangen eines ersten Hochfrequenzsignals (RFin), Mitteln (3, 4, 12, 15) zur Verstärkung dieses ersten Hochfrequenzsignals, um ein zweites verstärktes Hochfrequenzsignal (RF1) abzugeben, Mitteln (7) für die Messung der Leistung des zweiten verstärkten Hochfrequenzsignals (RF1), **dadurch gekennzeichnet, dass** diese Baugruppe Folgendes umfasst:
- Mittel (5, 16) zur Kopplung des verstärkten Hochfrequenzsignals auf einen ersten Ausgang (S1) der Baugruppe bei Empfang eines Verbindungssteuerungssignals,
- einen zweiten Eingang, um das Verbindungssteuerungssignal (Sc) zu empfangen, dass von der Zentraleinheit erzeugt wird, um die Kopplungsmittel zu steuern, wenn die Leistung des verstärkten Hochfrequenzsignals gleich einem nominalen Leistungswert (Pout) ist.

2. Baugruppe nach Anspruch 1, **dadurch gekennzeichnet, dass** die Kopplungsmittel einen Ultrahochfrequenzschalter (5) umfassen.

3. Baugruppe nach Anspruch 1, **dadurch gekennzeichnet, dass** die Baugruppe zwei Wege (9, 10) zur Verarbeitung des ersten Hochfrequenzsignals (RF1) aufweist, wobei die Verstärkungsmittel erste (12) und zweite Verstärkungsmittel (15) aufweisen, die jeweils auf dem ersten (9) und auf dem zweiten Verarbeitungsweg (10) angeordnet sind, um jeweils ein drittes verstärktes Hochfrequenzsignal (RF1', RF1") jeweils gleicher Leistung abzugeben, wobei die Kopplungsmittel (16) geeignet sind, um eingangsseitig die dritten Hochfrequenzsignale zu empfangen und an einem zweiten Ausgang (S2) des ersten, mit dem ersten Ausgang (S1) verbundenen Weges ein Differenzsignal, das der Differenz der dritten Signale entspricht, und an einem dritten Ausgang (S3) des zweiten Weges ein Summensignal abzugeben, das der Summe der dritten Signale entspricht und dem zweiten Signal gleich ist, um durch die Messmittel gemessen zu werden, wobei die Kopplungsmittel geeignet sind, um den zweiten und den dritten Ausgang (S2, S3) zu vertauschen.

4. Baugruppe nach Anspruch 3, **dadurch gekennzeichnet, dass** die Verarbeitungswege Verstärkungsdämpfungsmittel (11) und erste Signalphasenverschiebungsmittel (14) aufweisen.

5. Baugruppe nach einem der Ansprüche 3 bis 4, **dadurch gekennzeichnet, dass** vor mindestens einem der ersten und zweiten Verstärkungsmittel ein Vorverstärker (3) angeordnet ist.

6. Baugruppe nach einem der Ansprüche 3 bis 5, **dadurch gekennzeichnet, dass** mindestens eines der ersten und zweiten Verstärkungsmittel einen Festkörperleistungsverstärker (SSPA) umfasst.

7. Baugruppe nach einem der Ansprüche 3 bis 6, **dadurch gekennzeichnet, dass** die Kopplungsmittel einen hybriden Koppler umfassen.

8. Baugruppe nach einem der Ansprüche 3 bis 7, **dadurch gekennzeichnet, dass** einer der Wege zweite 180°-Phasenverschiebungsmittel (13) umfasst, die dazu bestimmt sind, durch die Steuerungsmittel gesteuert zu werden, um die Vertauschung der Abgabe der Signale durchzuführen.

9. Vorrichtung von der Art einer Parabel oder einer Luneberg-Linse zum Senden von Hochfrequenzsignalen, welche dazu bestimmt ist, im Fokus von Mitteln zur Fokussierung von Hochfrequenzsignalen angeordnet zu werden, **dadurch gekennzeichnet, dass** sie eine Verstärkerbaugruppe nach einem der Ansprüche 1 bis 8 aufweist.

10. Anordnung aus Endgerät und Antenne zum Senden von Hochfrequenzsignalen mit Mitteln zur Fokussierung von Hochfrequenzsignalen, in deren Fokus mindestens eine Vorrichtung zum Senden von Hochfrequenzsignalen angeordnet ist, **dadurch gekennzeichnet, dass** die Anordnung eine Vorrichtung nach Anspruch 9 umfasst.
